# EUROPEAN PATENT SPECIFICATION

(11) **EP 1 942 503 B1**
(45) Date of publication and mention of the grant of the patent: **28.12.2011**
(21) Application number: 06722222.4
(22) Date of filing: 31.03.2006
(51) Int. Cl.: G11C 5/00

(54) **MEMORY DEVICE WITH CONTROL CHIP HAVING COMPATIBLE CONFIGURE FUNCTION AND MANUFACTURING METHOD THEREOF**
SPEICHERBAUSTEIN MIT STEUERCHIP MIT KOMPATIBLER KONFIGURIERFUNKTION UND HERSTELLUNGSVERFAHREN DAFÜR
DISPOSITIF MÉMOIRE AVEC PUCE DE COMMANDE À FONCTION DE CONFIGURATION COMPATIBLE, ET SA MÉTHODE DE FABRICATION

(30) Priority: 28.10.2005 CN 200510100900
(43) Date of publication of application: 09.07.2008
(73) Proprietor: Shenzhen Chipsbank Technologies Co., Ltd., Guangdong 518057 (CN)
(72) Inventor: ZHANG, Hualong, Guangdong 518057 (CN)
(74) Representative: Hengelhaupt, Jürgen
(86) International application number: PCT/CN2006/000570
(87) International publication number: WO 2007/048287

(56) References cited:
- EP-A- 1 367 496
- WO-A-95/19608
- WO-A-03/012657
- WO-A-2004/027617
- CN-A- 1 570 881
- CN-A- 1 577 292
- JP-A- 2003 091 704

## Description

### BACKGROUND OF THE INVENTION

### 1. Field of Invention

The invention relates to flash memory access and more particularly to a control chip interconnecting PC and flash memory medium and method of enabling the control chip to program the flash memory medium to be accessible by the PC.

### 2. Description of Related Art

A wide variety of flash memory medium are available in recent years due to the fast progress of information technology. However, flash of different type (different ID) has to be operated and managed differently. Thus, to make data storage devices able to be accessed by a PC (personal computer), firmware used by flash controller for one flash memory medium may be different from that of another flash memory medium. Thus, it is desirable to provide apparatus and method for enabling a PC to access any type of flash memory mediums.

WO 03/012657 A2 wherein the preamble of claim 1 is based provides a detachable add-on card unit to a host system that combines mass storage capability and a processor on the same card. The non-volatile mass storage memory may contain program storage as well as card system data and user data. The end user of the card can program applications into the program storage. The combination of mass storage and a processor allow the card to store and execute programs.

WO 2004/027617 discloses a field-operable stand-alone apparatus for recovering data from corrupted flash media and regenerated damaged flash media. Once the file indicia are found, the location of corresponding file data is identified, whereupon the file data are read and stored. Converter chip 40 detects when a flash-memory card has been inserted into one of the connectors 62, 64, 66, 68 and configures itself to read files from the inserted card using the pin interface of F. 5 corresponding to the card type (see paragraph [0071] of the description).

### SUMMARY OF THE INVENTION

It is therefore one object of the invention to provide an storage apparatus 4 able to connect to a PC, comprising a non-volatile memory device 2and a control chip 1 including a RAM (random access memory); a ROM (read only memory) containing programs to be run by the control chip; and a processor, wherein the control chip is adapted to run the programs of the ROM to read an ID (identification) segment of the non-volatile memory device, obtain data about type and capacity of the non-volatile memory device according to the ID, program the non-volatile memory device as a main firmware segment 21 stored with compatible configuration codes, an auxiliary firmware segment 22 stored with programs of data encryption, flash memory device activation, and data compression, and a data storage segment so as to enable the PC to access the non-volatile memory device via the control chip.

It is another object of the invention to, in an storage apparatus including a non-volatile memory device and a control chip including a RAM (random access memory), a ROM (read only memory), and a processor, provide a method comprising the steps of interconnecting a PC and the storage apparatus 4; causing the PC to detect the connection of the storage apparatus 4; causing the PC to enable the control chip to read programs from the ROM; causing the control chip to run the programs to read an ID (identification) segment of the non-volatile memory device for obtaining data about type and capacity of the non-volatile memory device; sending the type and the capacity of the non-volatile memory device back to the PC; causing the PC to command the control chip to program the non-volatile memory device as one including a first memory segment, a second memory segment, and a data storage segment; causing the PC to send compatible configuration codes representing the type and the capacity of the non-volatile memory device through the control chip to write same into the first memory segment in a fixed form to form a main firmware segment 21, and send other programs including data encryption, flash memory device activation, and data compression through the control chip to write into the second memory segment in a fixed form to form an auxiliary firmware segment 22; causing the PC to command the control chip to format the data storage segment.

The above and other objects, features and advantages of the invention will become apparent from the following detailed description taken with the accompanying drawings.

### BRIEF DESCRIPTION OF THE DRAWINGS

FIG. 1 is a block diagram of a first preferred embodiment of an apparatus interconnecting a PC and a flash memory medium according to the invention;
FIG. 2 is a block diagram of a second preferred embodiment of an apparatus interconnecting a PC and a flash memory medium according to the invention;
FIG. 3 is a block diagram of a third preferred embodiment of an apparatus interconnecting a PC and a flash memory medium according to the invention; and
FIG. 4 is a flow chart of programming a flash memory medium by a control chip of an apparatus interconnecting a PC and the flash memory medium according to the invention.

### DETAILED DESCRIPTION OF THE INVENTION

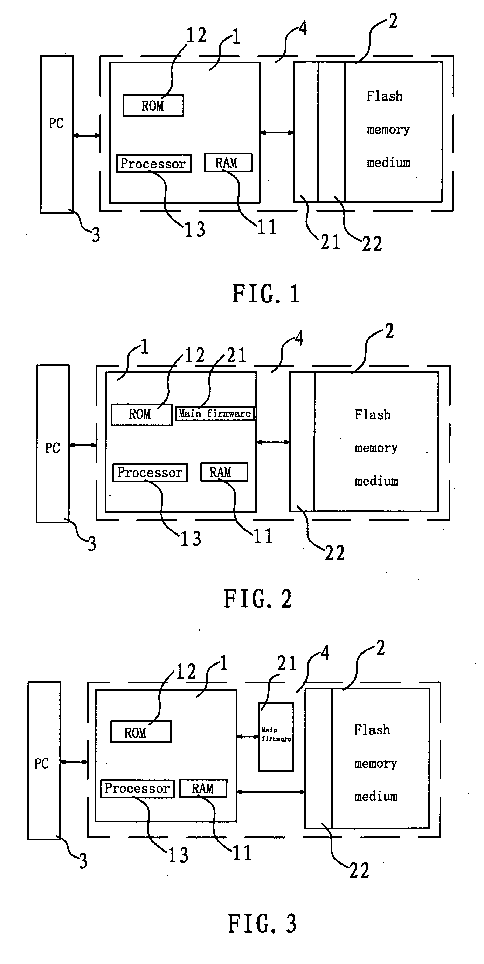

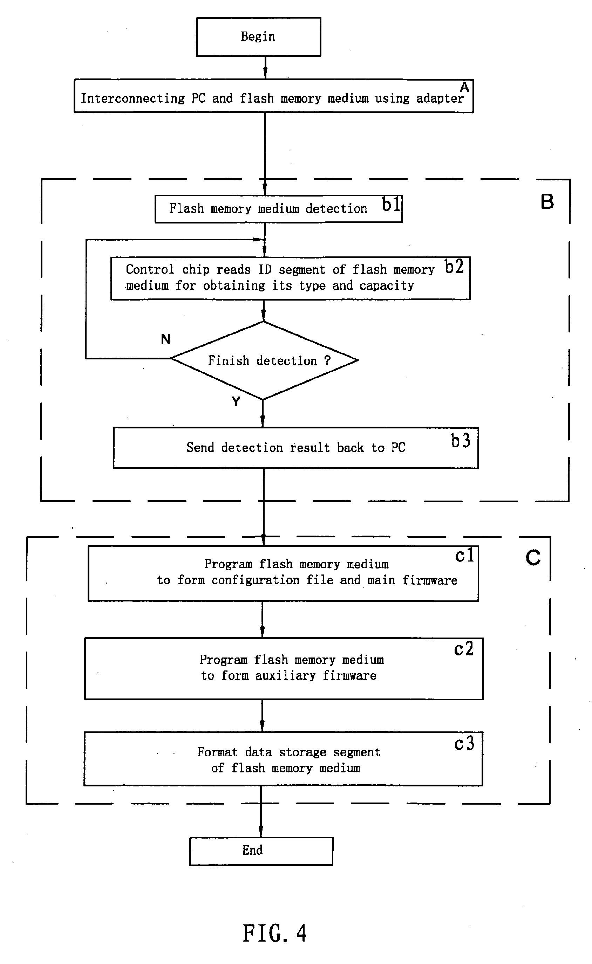

Referring to FIGS. 1 to 4, a memory programming method according to the invention is illustrated. As shown in FIG. 4, first, interconnect a PC 3 and an apparatus 4 comprising of a flash memory medium 2 and a control chip 1 and possibly a non-volatile memory device (as 21 in fig.3) (step A). The control chip 1 including a RAM (random access memory) 11, a ROM (read only memory) 12, and a processor 13 and possibly a non-volatile memory device (as 21 in fig.2) . Preferably, the RAM 11 is a static random access memory (SRAM). Next, the PC 3 enables the processor 13 to read programs stored in the ROM 12 after detecting the connection of the flash memory medium 2 via the controller 1 (step b1 of B). The processor 13 then runs the programs to read an ID

(identification) segment of the flash memory medium 2 for obtaining data about type and capacity of the flash memory medium 2 (step b2 of B). The detection continues until it successes. The detection result containing the type and the capacity of the flash memory medium 2 is sent back to the PC 3 via the control chip 1 (step b3 of B). Next, the PC 3 commands the processor 13 to program the flash memory medium 2 as one including a first memory segment 21, a second memory segment 22, and a data storage segment. Next, the PC 3 sends compatible configuration codes representing the type and the capacity of the flash memory medium 2 through the control chip 1 to write into the first memory segment 21 in a fixed form to form a main firmware segment 21, (step c1 of C). and the PC 3 sends other programs including data encryption, flash memory medium activation, and data compression through the control chip 1 to write into the second memory segment 22 also in a fixed form to form an auxiliary firmware 22 (step c2 of C). Also, the PC 3 commands the control chip 1 to format the data storage segment of the flash memory medium 2 (step c3 of C). This finishes the programming of the flash memory medium 2.

Preferably, the main firmware segment 21 is implemented by a PROM (programmable read only memory), an EPROM (erasable programmable read only memory), an EEPROM (electrically erasable programmable read only memory), or flash memory medium.

The main firmware segment 21 can be located in the flash memory medium 2 as shown in a first preferred embodiment of FIG. 1, in the control chip 1 as shown in a second preferred embodiment of FIG. 2, or in the apparatus 4 but being external of the control chip 1 as shown in a third preferred embodiment of FIG. 3.

For example, in the market there is a type A flash memory medium produced by one manufacturer and there is a type B flash memory medium produced by a different manufacturer respectively. A user may manufacture storage apparatus using either type of flash media by following method provided by this invention. Thereafter, the apparatus does the programming as described above to write corresponding firmware 21 and firware22 into respective flash medium before formatting. Finally, the PC can access the two different flash memory medium.

While the invention herein disclosed has been described by means of specific embodiments, numerous modifications and variations could be made thereto by those skilled in the art without departing from the scope of the invention set forth in the claims.

## Claims

1. A storage apparatus (4) comprising a control chip (1) with reprogramming capability and a non-volatile memory device (2),
said control chip (1) including a RAM (11) and a ROM (12) containing programs to be run by the control chip (1), so as to enable a PC (3) to access the non-volatile memory device (2) via the control chip (1).
**characterized in that** the control chip (1) is adapted to run the programs of the ROM (12) to read an ID segment of the non-volatile memory device (2), obtain data about type and capacity of the non-volatile memory device (2) according to the ID segment, program the non-volatile memory device (2) as a main firmware segment (21) storing compatible configuration codes representing the type and the capacity of the non-volative memory device (2), as an auxiliary firmware segment (22) storing programs of data encryption, flash memory device activation, and data compression, and as a data storage segment.

2. The apparatus of claim 1, wherein the RAM (11) is a static random access memory, SRAM.

3. The apparatus of claim 2, wherein the main firmware segment (21) and auxiliary firmware segment (22) is in a PROM, an EPROM, or an EEPROM, or a flash medium.

4. The apparatus of claim 2 wherein the non-volatile memory device (2) is a ROM, a hard disk drive, or a compact disc.

5. A manufacturing method for a storage apparatus (4) comprising a control chip (1) with reprogramming capability and a non-volatile memory device (2), comprising the steps of:
interconnecting a PC (3) and the storage apparatus (4);
causing the PC to detect the connection of the storage apparatus (4);
causing the PC to enable the control chip (1) to read programs from a ROM on the control chip (1);
causing the control chip (1) to run the programs to read an ID segment of the non-volatile memory device (2) for obtaining data about type and capacity of the non-volatile memory device (2);
sending the type and the capacity of the non-volatile memory device (2) back to the PC;
causing the PC to command the control chip (1) to program the non-volatile memory device (2) as one including a first memory segment (21), a second memory segment (22), and a data storage segment;
causing the PC to send compatible configuration codes representing the type and the capacity of the non-volatile memory device (2) to the control chip (1) for writing same into the first memory segment (21) in a fixed form to form a main firmware segment (21), and send other programs including data encryption, flash memory device activation, and data compression to the control chip (1) for writing into the second memory segment (22) in a fixed form to form an auxiliary firmware segment (22);
causing the PC to command the control chip to format the data storage segment.

6. The method of claim 5, wherein the RAM (11) is a static random access memory, SRAM.

7. The method of claim 5, wherein the main firmware segment (21) and auxiliary firmware segment (22) is in a PROM, an EPROM, or an EEPROM, or a flash medium.

8. The method of claim 5 wherein the non-volatile memory device (2) is a ROM, a hard disk drive, or a compact disc.

## Patentansprüche

1. Speichergerät (4) mit einem Steuerchip (1) mit Umprogrammierfähigkeit und einem nicht flüchtigen Speicherbaustein (2),
wobei der Steuerchip (1) einen RAM (11) und einen ROM (12) umfasst, welcher Programme enthält, die von dem Steuerchip (1) auszuführen sind, so dass ein PC (3) über den Steuerchip (1) Zugriff auf den nicht flüchtigen Speicherbaustein (2) erhalten kann,
**dadurch gekennzeichnet, dass** der Steuerchip (1) geeignet ist, die Programme des ROM (12) auszuführen, um ein ID-Segment des nicht flüchtigen Speicherbausteins (2) zu lesen, Daten über Art und Kapazität des nicht flüchtigen Speicherbausteins (2) gemäß dem ID-Segment zu erhalten, den nicht flüchtigen Speicherbaustein (2) als Haupt-Firmwaresegment (21) zu programmieren, das kompatible Konfigurationscodes speichert, die die Art und Kapazität des nicht flüchtigen Speicherbausteins (2) darstellen, als Hilfs-Firmwaresegment (22) zu programmieren, das Programme der Datenverschlüsselung, Flash-Speicherbaustein-Aktivierung und Datenkompression speichert, und als Datenspeichersegment zu programmieren.

2. Gerät nach Anspruch 1, wobei der RAM (11) ein statischer Direktzugriffsspeicher, ein SRAM, ist.

3. Gerät nach Anspruch 2, wobei sich das Haupt-Firmwaresegment (21) und das Hilfs-Firmwaresegment (22) in einem PROM, einem EPROM oder einem EEPROM oder in einem Flash-Medium befindet.

4. Gerät nach Anspruch 2, wobei der nicht flüchtige Speicherbaustein (2) ein ROM, ein Festplattenlaufwerk oder eine CD ist.

5. Herstellungsverfahren für ein Speichergerät (4) mit einem Steuerchip (1) mit Umprogrammierfähigkeit und einem nicht flüchtigen Speicherbaustein (2), das die folgenden Schritte umfasst:
Verbinden eines PCs (3) mit dem Speichergerät (4);
Feststellen des Anschlusses des Speichergerätes (4) durch den PC;
Aktivieren des Steuerchips (1) durch den PC, so dass er Programme von einem ROM auf dem Steuerchip (1) lesen kann;
Ausführen der Programme durch den Steuerchip (1), um ein ID-Segment des nicht flüchtigen Speicherbausteins (2) zu lesen, so dass man Daten über Art und Kapazität des nicht flüchtigen Speicherbausteins (2) erhält;
Zurücksenden von Art und Kapazität des nicht flüchtigen Speicherbausteins (2) an den PC;
Befehl durch den PC an den Steuerchip (1), den nicht flüchtigen Speicherbaustein (2) so zu programmieren, dass er ein erstes Speichersegment (21), ein zweites Speichersegment (22) und ein Datenspeichersegment enthält;
Senden kompatibler Konfigurationscodes durch den PC, die die Art und Kapazität des nicht flüchtigen Speicherbausteins (2) darstellen, an den Steuerchip (1), damit dieser in fester Form in das erste Speichersegment (21) eingespeichert wird, um ein Haupt-Firmwaresegment (21) zu bilden, und Senden anderer Programme einschließlich Datenverschlüsselung, Flash-Speicherbaustein-Aktivierung und Datenkompression an den Steuerchip (1) zum Einspeichern in fester Form in das zweite Speichersegment (22), um ein Hilfs-Firmwaresegment (22) zu bilden;
Befehl durch den PC an den Steuerchip zur Formatierung des Datenspeichersegmentes.

6. Verfahren nach Anspruch 5, wobei der RAM (11) ein statischer Direktzugriffsspeicher, ein SRAM, ist.

7. Verfahren nach Anspruch 5, wobei sich das Haupt-Firmwaresegment (21) und das Hilfs-Firmwaresegment (22) in einem PROM, einem EPROM oder einem EEPROM oder in einem Flash-Medium befinden.

8. Verfahren nach Anspruch 5, wobei der nicht flüchtige Speicherbaustein (2) ein RM, ein Festplattenlaufwerk oder eine CD ist.

## Revendications

1. Appareil mémoire (4) comportant une puce de commande (1) avec capacité de reprogrammation et un dispositif mémoire non-volatile (2),
ladite puce de commande (1) comprenant une RAM (11) et une ROM (12) comportant des programmes à être exécutés par la puce de commande (1) de manière qu'un PC (3) peut avoir accès au dispositif mémoire non-volatile (2) par la puce de commande (1),
**caractérisé en ce que** la puce de commande (1) est apte à exécuter les programmes du ROM (12) pour lire un segment ID du dispositif mémoire non-volatile (2), obtenir des données sur le type et la capacité du dispositif mémoire non-volatile (2) selon le segment ID, programmer le dispositif mémoire non-volatile (2) en tant que segment de firmware principal (21) mémorisant des codes compatibles de configuration représentant le type et la capacité du dispositif mémoire non-volatile (2), en tant que segment de firmware auxiliaire (22) mémorisant des programmes de cryptage de données, activation du dispositif mémoire flash et compression de données, et en tant que segment de mémorisation de données.

2. Appareil selon la revendication 1, la RAM (11) étant une mémoire statique à accès aléatoire, SRAM.

3. Appareil selon la revendication 2, le segment de firmware principal (21) et le segment de firmware auxiliaire (22) étant dans une PROM, une EPROM ou une EEPROM, ou un médium flash.

4. Appareil selon la revendication 2, le dispositif mémoire non-volatile (2) étant une ROM, une unité de disque fixe ou une CD.

5. Méthode de fabrication pour un appareil mémoire (4) comprenant une puce de commande (1) avec capacité de reprogrammation et un dispositif de mémoire non-volatile (2) comprenant les étapes suivantes:
interconnecter d'un PC (3) avec l'appareil mémoire (4);
amener le PC à détecter la connexion de l'appareil mémoire (4);
amener le PC à activer la puce de commande (1) pour lire des programmes de la ROM sur la puce de commande (1);
amener la puce de commande (1) à exécuter les programmes pour lire un segment ID du dispositif mémoire non-volatile (2) en vue d'obtenir des données sur le type et la capacité du dispositif mémoire non-volatile (2);
retourner le type et la capacité du dispositif mémoire non-volatile (2) au PC;
amener le PC à commander à la puce de commande (1) la programmation du dispositif mémoire non-volatile (2) de manière qu'il comprend un premier segment de mémoire (21), un deuxième segment de mémoire (22) et un segment de mémorisation de données;
amener le PC à envoyer des codes compatibles de configuration représentant le type et la capacité du dispositif mémoire non-volatile (2) à la puce de commande (1) pour l'écrire dans le premier segment de mémoire (22) en forme fixe pour former un segment de firmware principal (21), et envoyer d'autres programmes comprenant le cryptage de données, l'activation du dispositif mémoire flash et la compression de données à la puce de commande (1) pour écrire dans le deuxième segment de mémoire (22) en forme fixe pour former un segment de firmware auxiliaire (22);
amener le PC à commander à la puce de commande (1) le formatage du segment de mémorisation de données.

6. Méthode selon la revendication 5, la RAM (11) étant une mémoire statique à accès aléatoire, SRAM.

7. Méthode selon la revendication 5, le segment de firmware principal (21) et le segment de firmware auxiliaire (22) étant dans une PROM, une EPROM ou une EEPROM, ou un médium flash.

8. Méthode selon la revendication 5, le dispositif mémoire non-volatile (2) étant une ROM, une unité de disque fixe ou une CD.
